# EUROPEAN PATENT SPECIFICATION

(11) **EP 1 434 750 B1**
(45) Date of publication and mention of the grant of the patent: **02.08.2006**
(21) Application number: 02801065.0
(22) Date of filing: 08.10.2002
(51) Int. Cl.: C04B 41/51, H05K 1/09, H01L 23/498

(54) **THICK FILM CONDUCTOR COMPOSITIONS FOR USE ON ALUMINUM NITRIDE SUBSTRATES**
DICKFILM-LEITERZUSAMMENSETZUNGEN ZUR VERWENDUNG AUF ALUMNIUMNITRIDSUBSTRATEN
COMPOSITIONS DE CONDUCTEUR EN COUCHE EPAISSE UTILISABLES SUR DES SUBSTRATS DE NITRURE D'ALUMINIUM

(30) Priority: 09.10.2001 US 328153 P
(43) Date of publication of application: 07.07.2004
(73) Proprietor: E. I. du Pont de Nemours and Company, Wilmington, Delaware 19898 (US)
(72) Inventor: WANG, Yueli, Morrisville, NC 27560 (US); CARROLL, Alan, Frederick, Raleigh, NC 27612 (US)
(74) Representative: Towler, Philip Dean
(86) International application number: PCT/US2002/033469
(87) International publication number: WO 2003/031373

(56) References cited:
- EP-A- 0 913 371
- US-A- 3 929 674
- US-A- 4 322 316
- US-A- 6 103 146

## Description

### FIELD OF THE INVENTION

The invention is directed to a thick film composition for use on an aluminum nitride substrate. The composition includes a boron containing reactant and a metal oxide that promotes adhesion to the substrate.

### BACKGROUND OF THE INVENTION

In recent years aluminum nitride substrates for circuit boards have been employed for use in high-temperature environments because of their high heat conduction coefficient. However, in order to adhere metal conductors to aluminum nitride substrates, it becomes necessary to use thick film compositions that are capable of providing a thin reactive layer (oxide film) formed between the metal found in the composition and the substrate by introducing the metal in atomic form to the surface of the substrate. The metal, which is extremely active, chemically bonds with excess oxygen that exists on the surface of the substrate. US Patent Number 6,103,146 to Okamoto describes such a composition for use on an aluminum nitride substrate wherein a conductive powder and a metal boride are dispersed in an organic medium. US 6,103,146 discloses thick film conductor paste compositions suitable for application to aluminium nitride substrates. The compositions comprise a conductive powder and a boride dispersed in an organic medium. The present invention improves the adhesion performance of the existing compositions.

### SUMMARY OF THE INVENTION

The invention is directed to a thick film composition for use on an aluminum nitride substrate, comprising:
a) an electrically conductive powder;
b) a boron-containing reactant selected from elemental boron, TiB₂, ZrB₂, HfB₂, UB₂, NbB₂, TaB₂, CrB₂, CoB, MoB₂, W₂B₅, CaB₆, SrB₆, BaB₆, LaB₆, CeB₆, PrB₆, NdB₆, SmB₆, EuB₆, Ni₃B₆, Ni₂B₆, and mixtures thereof; and
c) a metal oxide selected from Co₃O₄, TiO₂, Fe₂O₃ and
mixtures thereof; wherein components a) to c) are dispersed in an organic medium, and wherein the boron-containing reactant is present in an amount of no more than 1.6% by weight of the total composition.

### DETAILED DESCRIPTION OF INVENTION

The invention is a thick film composition for use on an aluminum nitride substrate. Thick film technology, which includes compositions thereof, is an established method in the electronic industry to efficiently manufacture hybrid electronic circuitry. The main components of the thick film conductor composition described herein are a conductor powder, a boron containing reactant, and a metal oxide dispersed in an organic medium. The components are discussed below.

### A. Conductor Powder

Generally, a thick film composition comprises a functional phase that imparts appropriate electrically functional properties to the composition. The functional phase comprises electrically functional powders dispersed in an organic medium that acts as a carrier for the functional phase. The composition is fired to bum out the organics and to impart the electrically functional properties. Prior to firing, a processing requirement may include an optional heat treatment such as drying, curing, reflow, and others known to those skilled in the art of thick film technology. "Organics" comprise polymer or resin components of a thick film composition.

The electrically functional powders in the present thick film composition are conductor powders and may comprise a single type of metal powder, mixtures of metal powders, alloys, or compounds of several elements. The particle diameter and shape of the metal powder is not particularly important as long as it is appropriate to the application method. Some examples of such powders include: gold, silver, copper, nickel, aluminum, platinum, palladium, molybdenum, tungsten, tantalum, tin, indium, lanthanum, gadolinium, boron, ruthenium, cobalt, titanium, yttrium, europium, gallium, sulfur, zinc, silicon, magnesium, barium, cerium, strontium; lead, antimony, conductive carbon, and combinations thereof and others common in the art of thick film compositions.

### B. Boron Containing Reactant

The boron containing reactant is selected from: combinations of boron and a metallic element which include binary, ternary and higher compounds of boron and a metallic element (called metal borides); elemental boron (hydrated or anhydrous) and a mixture of the listed reactants. In addition, included are compounds that generate B₂O₃ upon heating in the temperature range of 600-1000°C and all ranges contained therein in air. The metal borides include TiB₂, ZrB₂, HfB₂, UB₂, NbB₂, TaB₂, CrB₂, CoB, MoB₂, W₂B₅, CaB₆, SrB₆, BaB₆, LaB₆, CeB₆, PrB₆, NdB₆, SmB₆, EuB₆, Ni₃B₆, and Ni₂B₆.

The level of the boride reactant added to the composition is determined by the extent that it does not cause poor solder wetting as a result of the B₂O₃ formed from boron in the firing process that becomes vitrified and covers the conductor surface. The unwanted decreased solder wetting effect of the B₂O₃ is related to the type and form of noble metal used, that is, whether pure or alloy; the metal oxide additive; and the density of the thick film after firing. Consequently, through selection of combinations, it is possible to inhibit formation of vitreous B₂O₃ on or migration of vitreous B₂O₃ to the thick film surface.

The amount of boron containing reactant contained in the composition is no more than 1.6 parts by weight per 100 parts by weight based on total composition in order to apply the thick film conductor composition on an aluminum nitride substrate without causing poor solder wetting.

### C. Metal Oxide

The metal oxide is selected from Co₃O₄, Fe₂O₃, TiO₂ and mixtures thereof. The metal oxide (1) reacts with the aluminum nitride substrate in the presence of the boron containing reactant to form ternary metal aluminate compounds or quaternary metal boroaluminate compounds forming an adhesive bond and/or; (2) modifies the vitrification (glass formation) of the boron containing reactant upon its oxidation thereby improving the solder wettability of the composition.

The metal oxide can be produced several ways; such as, oxidation of metals, decomposition of metal carbonates, conversion from metal sulfides, sulfates, phosphates, nitriates, nitrides, borides, halides, etc., under firing conditions for processing the compositions.

The metal oxide in the composition is preferably no more than 2 parts by weight per 100 parts by weight based on the total composition. The boron containing reactant and metal oxide in combination are preferably no more than 3 parts by weight per 100 parts by weight of the total composition. The metal oxide and the boron containing reactant react with the aluminum nitride substrate during the firing process, producing an oxidation reaction product (2Al₂O₃.B₂O₃), which contributes to adhesion between the conductor and the substrate. For example, the combination of TiO₂ with anhydrous boron reacts with AIN in air to form B₂O₃, 2Al₂O₃.B₂O₃, and a TiO₂ modified B₂O₃ glass. The TiO₂ inhibits the formation and flow of the B₂O₃ glass thus improving solder wettability of the metallic conductor thick film composition.

In another example, the addition of Co₃O₄ to TiB₂ reacts with the AIN to form both 2Al₂O₃.B₂O₃ and CoAl₂O₄ interfacial (conductor - substrate interface) bond phases. The Co₃O₄ also inhibits the formation and flow of the B₂O₃ glass thus improving solder wettability.

### D. Optional Components

The powders described hereinabove are finely dispersed in an organic medium and are optionally accompanied by inorganic binders, ceramics, and fillers, such as other powders or solids. The function of an inorganic binder in a thick film composition is binding the particles to one another and to the substrate after firing. Examples of inorganic binders include glass binders (frits), metal oxides, and ceramics. Glass binders useful in the thick film composition are conventional in the art. Some examples include borosilicates and aluminosilicates glasses. Examples further include combinations of oxides, such as: B₂O₃, SiO₂, Al₂O₃, Bi₂O₃, CuO, CdO, CaO, BaO, ZnO, SiO₂, Na₂O, PbO, and ZrO which may be used independently or in combination to form glass binders. In addition, the thick film composition can also include other metal particles and inorganic binder particles to enhance various properties of the composition, such as adhesion, sintering, processing, brazeability, solderability, reliability, etc., during processing.

### E. Organic Medium

The powders are typically mixed with an organic medium (vehicle) by mechanical mixing to form a pastelike composition called "pastes", having suitable consistency and rheology for printing. A wide variety of inert liquids can be used as organic medium. The organic medium must be one in which the solids are dispersible with an adequate degree of stability. The rheological properties of the medium must be such that they lend good application properties to the composition. Such properties include: dispersion of solids with an adequate degree of stability, good application of composition, appropriate viscosity, thixotropic, appropriate wettability of the substrate and the solids, a good drying rate, good firing properties, and a dried film strength sufficient to withstand rough handling. The organic medium is conventional in the art and is typically a solution of polymer in solvent(s). The most frequently used resin for this purpose is ethyl cellulose. Other examples of resins include ethylhydroxyethyl cellulose, wood rosin, mixtures of ethyl cellulose and phenolic resins, polymethacrylates of lower alcohols, and monobutyl ether of ethylene glycol monoacetate can also be used. The most widely used solvents found in thick film compositions are ethyl acetate and terpenes such as alpha- or beta-terpineol or mixtures thereof with other solvents such as kerosene, dibutylphthalate, butyl carbitol, butyl carbitol acetate, hexylene glycol and high boiling alcohols and alcohol esters. In addition, volatile liquids for promoting rapid hardening after application on the substrate can be included in the vehicle. The preferred mediums are based on ethylcellulose and β-terpineol. Various combinations of these and other solvents are formulated to obtain the viscosity and volatility requirements desired.

The solids are mixed with an essentially inert liquid medium (vehicle) by mechanical mixing using a planetary mixer, then dispersed on a three roll mill to form a paste-like composition having suitable consistency and rheology for screen printing. The latter is printed as a "thick film" paste on an aluminum nitride substrate in the conventional manner as known to those in the art of thick film technology.

The ratio of organic medium in the thick film composition to the inorganic solids in the dispersion is dependent on the method of applying the paste and the kind of organic medium used. Normally to achieve good coverage, the dispersions will contain complementarily 50-91 % wt. inorganic solids and 50-9% wt. vehicle, as described above. The compositions of the present invention may, of course, be modified by the addition of other materials, which do not affect its beneficial characteristics. Such formulations are well within the state of the art.

The pastes are conveniently prepared on a three-roll mill. The viscosity of the pastes is typically within the following ranges when measured on a Brookfield HBT viscometer at low, moderate, and high shear rates:

| Shear Rate (sec⁻¹) | Viscosity (Pa *s) | |
|---|---|---|
| 0.2 | 100-5000 | |
| | 300-2000 | Preferred |
| | 600-1500 | Most Preferred |
| 4 | 40-400 | |
| | 100-250 | Preferred |
| | 120-200 | Most Preferred |
| 40 | 10-150 | |
| | 25-120 | Preferred |
| | 50-100 | Most Preferred |

### Test Procedure used in Examples

### Aged Adhesion

Printed parts are dried 5-15 minutes at 80-150°C. They are then fired three times in a belt furnace which has a 10 minute peak temperature cycle at 850°C; and a 30 minute descending temperature ramp back down from 850°C to ambient.

After firing three times, the parts have wires attached as follows. Wires are clipped onto the substrate so that they each run down the center of three pads. Then the wires/fired parts are dipped into Alpha 611 solder flux. The parts are then prewarmed on the solder bath and dipped for 10 seconds, and allowed to cool. Residual solder flux is cleaned from the soldered wire parts with a CH₂CL₂/methanol mixture. Parts are placed in an oven at 150°C for 48 hours, then removed and cooled.

The aged parts are placed in an apparatus for measuring the force necessary to separate the wire from the substrate. The force necessary is recorded. Also, the type of separation is noted, i.e., whether separation involves the wires pulling out of the solder pulls off the substrate. Over 15 Newtons is good adhesion. Over 20 Newtons is excellent adhesion. Adhesion of 12-14 Newtons is marginal and below 12 is unacceptable.

### EXAMPLES

This invention is described in further detail with practical examples (Examples 6 and 8-12) and comparative examples (Examples 1-5 and 7). In the examples, the mixing ratio of conductive powder, boride containing reactant, metal boride and organic medium (vehicle) is shown in Table 1 as percent by weight (wt. %) based on total composition. A typical test pattern with a conductor resistance test pattern and pads (2 x 2 mm) was prepared, and a thick film paste composition as given in Table 1 was screen printed using the typical adhesion test pattern on an aluminum nitride substrate measuring 1"x1"x0.25", dried, and fired at 850°C/30 minutes in a belt furnace in air atmosphere and repeated three times so that the thickness of the conductor after firing was about 11 µm-12 µm. Tests were preformed as described above. Table 2 shows results of the test method.

The examples show the following:
Example 1: It is demonstrated that only silver powder in the composition results in an inadequate bond of the composition to the AIN substrate.
Example 2: Boron added to the silver composition produces an inadequate bond of the composition to the AIN substrate.
Example 3: TiO₂ added to the silver composition results in inadequate bonding of the composition to the AIN substrate.
Example 4: Co₃O₄ added to silver composition produces an inadequate bond of the composition to the AlN substrate.
Example 5: This composition has a combination of Co₃O₄ and Ti02. The resulting composition is unable to bond to the AIN substrate.
Example 6: This composition has a combination of B and Co₃O₄. The composition is able to provide reasonable bonding strength to the AIN substrates. Compared to Examples 2 and 4, it suggests that both B and a metal oxide like Co₃O₄ are needed to promote adhesion.
Example 7: TiB₂ added to a silver composition produces an acceptable bond of lower strength than that formed with both TiB₂+ Co₃O₄ (or Fe₂O₃) additions (Examples 8 to 10). The TiB₂ additive produces a lower quality solder fillet (poor wetting).
Examples 8-12 show the added adhesion through use of the claimed invention.

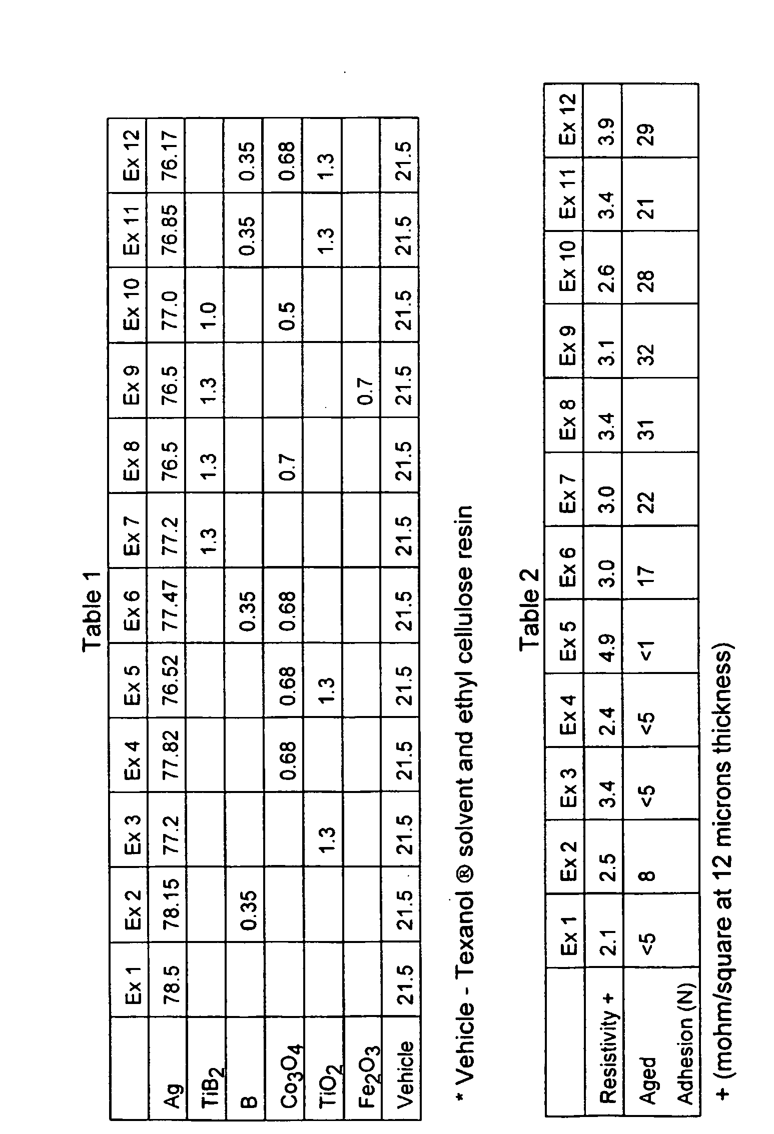

## Claims

1. A thick film composition for use on an aluminum nitride substrate, comprising:
a) an electrically conductive powder;
b) a boron-containing reactant selected from elemental boron, TiB₂, ZrB₂, HfB₂, UB₂, NbB₂, TaB₂, CrB₂, CoB, MoB₂, W₂B₅, CaB₆, SrB₆, BaB₆, LaB₆, CeB₆, PrB₆, NdB₆, SmB₆, EuB₆, Ni₃B₆, Ni₂B₆, and mixtures thereof; and
c) a metal oxide selected from Co₃O₄, TiO₂, Fe₂O₃ and mixtures thereof; wherein components a) to c) are dispersed in an organic medium, and wherein the boron-containing reactant is present in an amount of no more than 1.6% by weight of the total composition.

2. A composition as claimed in claim 1, **characterised in that** the boron-containing reactant is TiB₂ and the metal oxide is Co₃O₄ or Fe₂O₃.

3. A composition as claimed in claim 1, **characterised in that** the boron-containing reactant is elemental boron and the metal oxide is TiO₂ or a mixture of TiO₂ and Co₃O₄.

4. A composition as claimed in any preceding claim, **characterised in that** the conductive powder is selected from gold, silver, platinum, palladium, rhodium and mixtures and alloys thereof.

5. A composition as claimed in any preceding claim further comprising an inorganic binder.

6. A composition as claimed in any preceding claim **characterised in that** the metal oxide comprises no more than 2% by weight of the total composition.

7. A composition as claimed in any preceding claim **characterised in that** the boron-containing reactant and the metal oxide together comprise no more than 3% by weight of the total composition.

8. A composition as claimed in any preceding claim which is air-fireable.

9. An article comprising a composition as claimed in any preceding claim from which the organic medium has been volatilized.

10. The article according to claim 9 obtainable by firing a composition according to any one of claims 1 to 8.

## Patentansprüche

1. Dickfilmzusammensetzung zur Verwendung auf einem Aluminiumnitrit-Substrat, aufweisend:
a) ein elektrisch leitfähiges Pulver;
b) einen Reaktionspartner, der Bor enthält und ausgewählt ist aus elementarem Bor, TiB₂, ZrB₂, HfB₂, UB₂ NbB₂, TaB₂, CrB₂, CoB, MoB₂, W₂B₅, CaB₆, SrB₆, BaB₆, LaB₆, CeB₆, PrB₆, NdB₆, SmB₆, EuB₆, Ni₃B₆, Ni₂B₆ und Mischungen davon; sowie
c) ein Metalloxid, das ausgewählt ist aus Co₃O₄, TiO₂, Fe₂O₃ und Mischungen davon;
wobei die Komponenten a) bis c) in einem organischen Medium dispergiert sind und worin der Bor enthaltende Reaktionspartner in einer Menge von nicht mehr als 1,6 Gew.% der Gesamtzusammensetzung vorliegt.

2. Zusammensetzung nach Anspruch 1, **dadurch gekennzeichnet, dass** der Bor enthaltende Reaktant TiB₂ ist und das Metalloxid Co₃O₄ oder Fe₂O₃ ist.

3. Zusammensetzung nach Anspruch 1, **dadurch gekennzeichnet, dass** der Bor enthaltende Reaktant elementares Bor und das Metalloxid TiO₂ oder eine Mischung von TiO₂ und Co₃O₄ ist.

4. Zusammensetzung nach einem der vorgenannten Ansprüche, **dadurch gekennzeichnet, dass** das leitfähige Pulver ausgewählt ist aus: Gold, Silber, Platin, Palladium, Rhodium und Mischungen und Legierungen davon.

5. Zusammensetzung nach einem der vorgenannten Ansprüche, ferner aufweisend ein anorganisches Bindemittel.

6. Zusammensetzung nach einem der vorgenannten Ansprüche, **dadurch gekennzeichnet, dass** das Metalloxid nicht mehr als 2 Gew.% der Gesamtzusammensetzung ausmacht.

7. Zusammensetzung nach einem der vorgenannten Ansprüche, **dadurch gekennzeichnet, dass** der Bor enthaltene Reaktant und das Metalloxid zusammen nicht mehr als 3 Gew.% der Gesamtzusammensetzung ausmachen.

8. Zusammensetzung nach einem der vorgenannten Ansprüche, die in der Luft gebrannt werden kann.

9. Artikel, aufweisend eine Zusammensetzung nach einem der vorgenannten Ansprüche, aus der das organische Medium verflüchtigt worden ist.

10. Artikel nach Anspruch 9, der durch Brennen einer Zusammensetzung nach einem der Ansprüche 1 bis 8 erhalten werden kann.

## Revendications

1. Composition en couche épaisse utilisable sur un substrat de nitrure d'aluminium, comprenant:
a) une poudre électroconductrice;
b) un réactant contenant du bore choisi parmi le bore élémentaire, TiB₂, ZrB₂, HfB₂, UB₂ NbB₂, TaB₂, CrB₂, CoB, MoB₂, W₂B₅, CaB₆, SrB₆, BaB₆, LaB₆, CeB₆, PrB₆, NdB₆, SmB₆, EuB₆, Ni₃B₆, Ni₂B₆ et les mélanges de ceux-ci; et
c) un oxyde métallique choisi parmi Co₃O₄, TiO₂, Fe₂O₃ et les mélanges de ceux-ci;
dans laquelle les constituants a) à c) sont dispersés dans un milieu organique, et dans laquelle le réactant contenant du bore est présent en une quantité non supérieure à 1,6% en poids de la composition totale.

2. Composition selon la revendication 1, **caractérisée en ce que** le réactant contenant du bore est TiB₂ et l'oxyde métallique est Co₃O₄ ou Fe₂O₃.

3. Composition selon la revendication 1, **caractérisée en ce que** le réactant contenant du bore est le bore élémentaire et l'oxyde métallique est TiO₂ ou un mélange de TiO₂ et de Co₃O₄.

4. Composition selon l'une quelconque des revendications précédentes, **caractérisée en ce que** la poudre conductrice est choisie parmi l'or, l'argent, le platine, le palladium, le rhodium et les mélanges et alliages de ceux-ci.

5. Composition selon l'une quelconque des revendications précédentes, comprenant en outre un liant inorganique.

6. Composition selon l'une quelconque des revendications précédentes, **caractérisée en ce que** l'oxyde métallique ne représente pas plus de 2% en poids de la composition totale.

7. Composition selon l'une quelconque des revendications précédentes, **caractérisée en ce que** le réactant contenant du bore et l'oxyde métallique ne représentent ensemble pas plus de 3% en poids de la composition totale.

8. Composition selon l'une quelconque des revendications précédentes, qui est susceptible d'être cuite dans l'air.

9. Article comprenant une composition selon l'une quelconque des revendications précédentes, dont le milieu organique a été volatilisé.

10. Article selon la revendication 9, susceptible d'être obtenu en cuisant une composition selon l'une quelconque des revendications 1 à 8.
